# EUROPEAN PATENT APPLICATION

(11) **EP 4 432 801 A1**
(43) Date of publication of application: **18.09.2024**
(21) Application number: 22900569.9
(22) Date of filing: 30.11.2022
(51) Int. Cl.: H05K 9/00, H05K 1/18

(54) **CIRCUIT BOARD ASSEMBLY AND ELECTRONIC DEVICE**

(30) Priority: 02.12.2021 CN 202123032771 U
(71) Applicant: Huawei Technologies Co., Ltd., Shenzhen, Guangdong 518129 (CN)
(72) Inventor: ZHUANG, Baoshan, Shenzhen, Guangdong 518129 (CN); XIONG, Zhenxing, Shenzhen, Guangdong 518129 (CN); ZHAO, Caijun, Shenzhen, Guangdong 518129 (CN); XIONG, Jianbo, Shenzhen, Guangdong 518129 (CN)
(74) Representative: Epping - Hermann - Fischer
(86) International application number: PCT/CN2022/135682
(87) International publication number: WO 2023/098765

(57) **Abstract**

Embodiments of this application provide a circuit board assembly and an electronic device. In the circuit board assembly, at least one first shielding component is disposed on a periphery of a chip component, each first shielding component includes a shielding frame and a shielding cover, an end that is of the shielding frame and that is away from the shielding cover is fastened to a first circuit board, at least a part of the shielding cover is located between the chip component and a heat sink, and the shielding cover is movably connected to the shielding frame, so that the shielding cover can move in a vertical direction relative to the shielding frame. In this way, the first shielding component can adapt to chip components of different heights and different assembly gaps.

## Description

This application claims priority to Chinese Patent Application No. 202123032771.3, filed with the China National Intellectual Property Administration on December 2, 2021 and entitled "CIRCUIT BOARD ASSEMBLY AND ELECTRONIC DEVICE", which is incorporated herein by reference in its entirety.

### TECHNICAL FIELD

With continuous development of science and technology, mobile Internet provides high-definition and high-performance multimedia applications. Consequently, mobile data services increase rapidly. However, power consumption of mobile terminal devices also increases greatly. This poses unprecedented challenges to a heat dissipation design in limited space.

Currently, in a heat dissipation manner used for a heat generating chip in a mobile terminal, a heat sink is generally disposed on a side that is of the heat generating chip and that is away from a circuit board, and a surface of the heat sink is in contact with the heat generating chip, to implement good heat dissipation of the heat generating chip. In addition, electromagnetic interference suppression also needs to be performed on an exposed chip while heat dissipation is implemented. In a related technology, a shielding structure is generally disposed between the circuit board and the heat sink. Specifically, one end of the shielding structure is soldered on the circuit board, and the other end of the shielding structure presses against the heat sink. In addition, the shielding structure is located on a periphery of the heat generating chip, so that the heat sink, the shielding structure, and the circuit board enclose to form sealed space, to achieve shielding effect of avoiding signal interference caused by the outside to the heat generating chip.

However, the shielding structure in the conventional technology cannot adapt to chips of different heights and different assembly gaps.

### SUMMARY

Embodiments of this application provide a circuit board assembly and an electronic device, which can adapt to chip components of different heights and different assembly gaps.

According to a first aspect, an embodiment of this application provides a circuit board assembly.

The circuit board assembly includes a first circuit board, a chip component, and at least one heat sink. One side of the chip component is electrically connected to the first circuit board, and the other side of the chip component is in contact with the heat sink.

The circuit board assembly further includes: at least one first shielding component located on a periphery of the chip component. Each first shielding component includes: a shielding frame and a shielding cover. An end that is of the shielding frame and that is away from the shielding cover is fastened to the first circuit board, and at least a part of the shielding cover is located between the chip component and the heat sink. The shielding cover is movably connected to the shielding frame, so that the shielding cover can move in a vertical direction relative to the shielding frame.

In the circuit board assembly provided in this embodiment of this application, the at least one first shielding component is disposed on the periphery of the chip component, the shielding frame of the first shielding component is fastened to the first circuit board, the at least a part of the shielding cover is located between the chip component and the heat sink, and the shielding cover is movably connected to the shielding frame, so that the shielding cover can move in the vertical direction relative to the shielding frame. In this way, when the shielding cover is in contact with an assembly gap between the chip component and the heat sink, the shielding cover can adapt to chips of different heights and move in the vertical direction relative to the shielding frame, or the shielding cover can adapt to different assembly gaps between the chip component and the heat sink and move in the vertical direction relative to the shielding frame.

In addition, when the shielding cover is in contact with the assembly gap between the chip component and the heat sink, and the heat sink applies pressure to a heat sink cover, a movable connection between the shielding cover and the shielding frame can provide buffer space for the shielding frame, to avoid or reduce strength deformation of the first shielding component, and prevent the shielding frame from causing a collision damage to the first circuit board, to damage connection reliability between the shielding frame and the first circuit board.

In a possible implementation, the chip component includes a chip body and a second circuit board connected to the chip body. A surface that is of the second circuit board and that is away from the chip body is electrically connected to the first circuit board, and a surface that is of the chip body and that is away from the second circuit board is in contact with the heat sink. The surface that is of the second circuit board and that is away from the chip body is electrically connected to the first circuit board, so that an electrical connection between the chip component and the second circuit board can be implemented. The surface that is of the chip body and that is away from the second circuit board is in contact with the heat sink, so that the heat sink can dissipate heat for the chip component.

In a possible implementation, the circuit board assembly further includes a heat conducting member. The heat conducting member is located between the chip body and the heat sink. The heat conducting member is disposed between the chip body and the heat sink, so that heat conduction performance between the chip body and the heat sink can be improved, and the heat sink better dissipates heat for the chip component.

In a possible implementation, the chip component further includes a mechanical part. The mechanical part and the chip body are located on a same surface of the second circuit board, and the mechanical part is located on a periphery of the chip body. The at least a part of the shielding cover is located between the mechanical part and the heat sink.

The mechanical part located on the periphery of the chip body can protect the chip body to some extent, and avoid adverse impact on the chip body caused by large-scale exposure of the chip body. In addition, the at least a part of the shielding cover is located between the mechanical part and the heat sink, which can also prevent the shielding cover from directly contacting the chip body and causing a collision damage or scratch to the chip body.

In a possible implementation, the second circuit board is electrically connected to the first circuit board through at least one electrical connector. A projection region of the at least one electrical connector on the first circuit board may be located in a projection region of the first shielding component on the first circuit board.

The projection region of the electrical connector on the first circuit board is located in the projection region of the first shielding component on the first circuit board. This can ensure that the first shielding component covers the electrical connector and gaps between a plurality of electrical connectors, and ensure electromagnetic interference suppression of the first shielding component to the electrical connector, to avoid interference caused by the electromagnetic interference to electrical connection performance between the second circuit board and the first circuit board.

In a possible implementation, the circuit board assembly further includes a second shielding component. The second shielding component is located between the shielding cover and the heat sink. The second shielding component is disposed between the shielding cover and the heat sink, so that effect of shielding interference signals around the chip component can be further enhanced on the basis of electromagnetic interference suppression performed by the first shielding component on the chip component.

In a possible implementation, the second shielding component is of an elastic shielding material. The second shielding component is set as the elastic shielding material, the second shielding component can provide specific buffering effect for contact between the shielding cover and the heat sink when enhancing the effect of shielding interference signals around the chip component. When the heat sink applies pressure to a heat sink cover, the second shielding component can be subject to specific pressure, to reduce a pressure degree of the heat sink cover.

In a possible implementation, the shielding cover includes a first portion and a second portion connected to the first portion. At least a part of the first portion is located between the chip component and the heat sink, and the second portion is movably connected to the shielding frame, so that the shielding cover can move in the vertical direction relative to the shielding frame. The at least a part of the first portion is located between the chip component and the heat sink, and the second portion is movably connected to the shielding frame. In this way, the first portion may make, based on an actual height of the chip component or an assembly gap between the chip component and the heat sink, the shielding cover move in the vertical direction relative to the shielding frame.

In a possible implementation, the shielding frame includes a third portion and a fourth portion connected to the third portion. An end that is of the third portion and that is away from the fourth portion is fastened to the first circuit board, and the fourth portion is parallel to the first portion. The fourth portion is disposed to be parallel to the first portion of the shielding cover, a contact area between the shielding cover and the shielding frame can be increased, to increase a force area when the shielding cover and the shielding frame are in contact with each other, and avoid that when an end that is of the third portion of the shielding frame and that is away from the first circuit board is in contact with the first portion of the shielding cover, the first portion of the shielding cover is collided or broken off because an end area of the third portion of the shielding frame is small.

In a possible implementation, the second portion is movably connected to the third portion, so that the shielding cover can move in the vertical direction relative to the shielding frame. The second portion of the shielding cover is movably connected to the third portion of the shielding frame, to ensure that the shielding cover can move relative to the shielding frame.

In a possible implementation, the second portion is parallel to the third portion. The second portion of the shielding cover is parallel to the third portion of the shielding frame. When the shielding cover moves relative to the shielding frame, it can be ensured that relative position movement directions of the second portion of the shielding cover and the third portion of the shielding frame are consistent, to avoid interference or a collision damage caused by a movement of one of the second portion and the third portion.

In a possible implementation, a protruding portion is disposed on one of the second portion and the third portion, an opening is disposed on one of the second portion and the third portion, and the protruding portion moves back and forth in the opening in the vertical direction. The protruding portion moves back and forth in the opening in the vertical direction, so that the shielding cover and the shielding frame can move relative to each other in the vertical direction.

In a possible implementation, a size of the opening in the vertical direction is greater than a size of the protruding portion in the vertical direction. In this way, it can be ensured that the protruding portion has specific back-and-forth movement space in the opening in the vertical direction, so that the shielding cover and the shielding frame can move relative to each other in the vertical direction.

In a possible implementation, a first avoidance opening is disposed on the fourth portion, the second portion passes through the first avoidance opening, and the second portion moves back and forth in an extension direction of the first avoidance opening. The second portion of the shielding cover passes through the first avoidance opening on the fourth portion of the shielding frame, and the second portion of the shielding cover moves back and forth in the extension direction of the first avoidance opening, so that the shielding cover and the shielding frame can move relative to each other in the vertical direction.

In a possible implementation, a size of the second portion in the vertical direction is greater than a size of the fourth portion in the vertical direction. In this way, it can be ensured that the second portion of the shielding cover in the vertical direction has specific back-and-forth movement space in the extension direction of the first avoidance opening, so that the shielding cover and the shielding frame can move relative to each other in the vertical direction.

In a possible implementation, the shielding cover further includes a fifth portion. The fifth portion is connected to an end that is of the second portion and that is away from the first portion. The fifth portion is parallel to the fourth portion, and the fifth portion is configured to limit a movement range of the second portion when the second portion moves back and forth in the extension direction of the first avoidance opening.

In a possible implementation, a second avoidance opening is disposed on an end that is of the third portion and that is close to the first circuit board. The shielding cover further includes a sixth portion. The sixth portion is connected to an end that is of the second portion and that is away from the first portion. The sixth portion extends into the second avoidance opening, and the sixth portion moves back and forth in the second avoidance opening in the vertical direction. The sixth portion of the shielding cover moves back and forth in the second avoidance opening of the third portion of the shielding frame in the vertical direction, so that the shielding cover and the shielding frame can move relative to each other in the vertical direction.

In a possible implementation, the shielding cover further includes a seventh portion. The seventh portion is connected to an end that is of the sixth portion and that is away from the second portion. An extension direction of the first portion is consistent with an extension direction of the second portion. The seventh portion is added to the shielding cover, the seventh portion is connected to the end that is of the sixth portion and that is away from the second portion, and an extension direction of the seventh portion is consistent with the extension direction of the second portion, so that the seventh portion, the sixth portion, and the second portion can form an inner bend hook structure. This helps ensure structural stability when the sixth portion of the shielding cover moves back and forth in the second avoidance opening of the third portion of the shielding frame in the vertical direction.

In a possible implementation, the heat sink includes a heat sink body and a boss connected to the heat sink body. A surface that is of the boss and that is away from the heat sink body is in contact with the chip component.

According to a second aspect, an embodiment of this application provides an electronic device including any one of the foregoing circuit board assemblies.

The foregoing circuit board assembly is disposed in the electronic device. Because the circuit board assembly can adapt to chip components of different heights and different assembly gaps, adaptability of the chip components of different heights and different assembly gaps to the electronic device can be increased. Because reliability of the circuit board assembly is high, the circuit board assembly with high reliability may be disposed in the electronic device, to optimize experience effect of the electronic device. In addition, stability of signal transmission in the electronic device is ensured, and normal operation of the electronic device is ensured.

### BRIEF DESCRIPTION OF DRAWINGS

FIG. 1 is a schematic of a structure of a circuit board assembly in the conventional technology;
FIG. 2 is a schematic of a circuit board assembly in a falling scenario in the conventional technology;
FIG. 3 is a schematic in which a gap occurs when a circuit board assembly is mounted in the conventional technology;
FIG. 4 is a schematic of a structure of a circuit board assembly according to an embodiment of this application;
FIG. 5 is a schematic of a structure of a circuit board assembly according to an embodiment of this application;
FIG. 6 is a schematic of a structure of a first shielding component in a circuit board assembly according to an embodiment of this application;
FIG. 7A is a schematic of a structure of a first shielding component in a circuit board assembly according to an embodiment of this application;
FIG. 7B is a schematic of a structure of a first shielding component in a circuit board assembly according to an embodiment of this application;
FIG. 8A is a schematic of a structure of a first shielding component in a circuit board assembly according to an embodiment of this application;
FIG. 8B is a schematic of a structure of a first shielding component in a circuit board assembly according to an embodiment of this application;
FIG. 9A is a schematic of a structure of a first shielding component in a circuit board assembly according to an embodiment of this application;
FIG. 9B is a schematic of a structure of a first shielding component in a circuit board assembly according to an embodiment of this application;
FIG. 10A is a schematic of a structure of a first shielding component in a circuit board assembly according to an embodiment of this application;
FIG. 10B is a schematic of a structure of a first shielding component in a circuit board assembly according to an embodiment of this application;
FIG. 11A is a schematic of a structure of a first shielding component in a circuit board assembly according to an embodiment of this application;
FIG. 11B is a schematic of a structure of a first shielding component in a circuit board assembly according to an embodiment of this application;
FIG. 12 is a schematic of a structure in which a chip component in a circuit board assembly is disposed on a first circuit board according to an embodiment of this application;
FIG. 13 is a schematic of a structure in which a shielding frame of a first shielding component in a circuit board assembly is disposed on a first circuit board according to an embodiment of this application;
FIG. 14 is a schematic of a structure in which a shielding cover of a first shielding component in a circuit board assembly is disposed on a shielding frame according to an embodiment of this application;
FIG. 15 is a schematic of a structure in which a shielding cover of a second shielding component in a circuit board assembly is disposed on a heat sink according to an embodiment of this application;
FIG. 16 is a schematic of a structure of a circuit board assembly according to an embodiment of this application; and
FIG. 17 is a schematic of a structure of a circuit board assembly according to an embodiment of this application.

### Description of reference numerals:

100-circuit board assembly; 110-first circuit board; 120-chip component;
121-chip body; 122-second circuit board; 123-mechanical part;
130-heat sink; 131-heat sink body; 132-boss;
133-heat dissipation fin; 140-first shielding component; 141-shielding frame;
1411-third portion; 1412-fourth portion; 1413-opening;
1414-first avoidance opening; 1415-second avoidance opening; 142-shielding cover;
1421-first portion; 1422-second portion; 1423-protruding portion;
1424-fifth portion; 1425-sixth portion; 1426-seventh portion;
150-heat conducting member; 160-electrical connector; 170-second shielding component;
200-shielding structure; and 300-ground.

### DESCRIPTION OF EMBODIMENTS

The terms used in embodiments of this application are only used to explain specific embodiments of this application, and are not intended to limit this application. The following will describe the implementations of embodiments of this application in detail with reference to the accompanying drawings.

Board-level application of a heat source chip on a printed circuit board (Printed Circuit Board, PCB) in a communication device usually uses an electromagnetic interference (Electromagnetic Interference, EMI) suppression design including two layers of regions. In other words, generally, the entire heat source chip and a connection solder joint between the heat source chip and the circuit board need to be shielded.

As higher requirements on transmission efficiency and capacity are imposed, a layout of the heat source chip on the printed circuit board in the communication device becomes denser, and space between chips is further compressed due to an increase in a quantity of chips. Therefore, new challenges are posed to electromagnetic interference and heat dissipation of the chips. Currently, a common shielding solution is usually to use a conductive material, a wave-absorbing material, or the like for suppression and shielding, to implement shielding effect around a chip. However, a shielding material used in the conventional chip shielding solution occupies large space, is severely constrained by a heat dissipation structure design, and cannot meet a layout requirement in high-density space. Consequently, shielding performance is poor, and a capability of suppressing electromagnetic interference between the chips is weak. Therefore, with reference to a chip application scenario, a requirement for implementing a miniaturized electromagnetic shielding solution in which a printed circuit board and a heat dissipation structure are coupled is increasingly urgent.

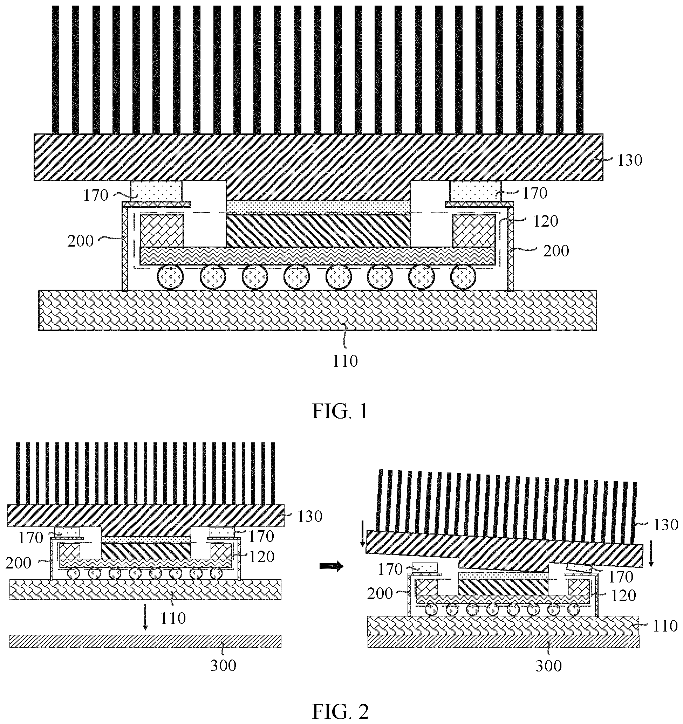

In a related technology, as shown in FIG. 1 to FIG. 3, a heat sink 130 is generally disposed on a side that is of a heat generating chip (namely, a chip component 120) and that is away from a circuit board (namely, a first circuit board 110), and a surface of the heat sink 130 is in contact with the chip component 120, to implement good heat dissipation of the chip component 120. In addition, a shielding structure 200 is further disposed between the first circuit board 110 and the heat sink 130. Specifically, one end of the shielding structure 200 is soldered on the first circuit board 110, the other end of the shielding structure 200 presses against the heat sink 130, and the shielding structure 200 is located on a periphery of the chip component 120, so that the heat sink 130, the shielding structure 200, and the first circuit board 110 enclose to form sealed space, to achieve shielding effect of avoiding signal interference caused by the outside to the chip component 120.

However, the shielding structure 200 is assembled at a fixed mounting height, and cannot adapt to chip components 120 of different heights and different assembly gaps. For example, to further enhance the shielding effect, an elastic conductive material (namely, a second shielding component 170) is generally disposed between the heat sink 130 and the shielding structure 200. However, in an assembly scenario with limited space, the heat sink 130 cannot be in contact with a heat source surface of the chip component 120 due to an extreme compression height and compression force of the elastic conductive material. This affects heat dissipation effect.

Based on this, an embodiment of this application provides a circuit board assembly. At least one first shielding component is disposed on a periphery of a chip component, a shielding frame of the first shielding component is fastened to a first circuit board, at least a part of a shielding cover is located between the chip component and a heat sink, and the shielding cover is movably connected to the shielding frame, so that the shielding cover can move in a vertical direction relative to the shielding frame. In this way, when the shielding cover is in contact with an assembly gap between the chip component and the heat sink, the shielding cover can adapt to chips of different heights and move in a vertical direction relative to the shielding frame, or the shielding cover can adapt to different assembly gaps between the chip component and the heat sink and move in a vertical direction relative to the shielding frame.

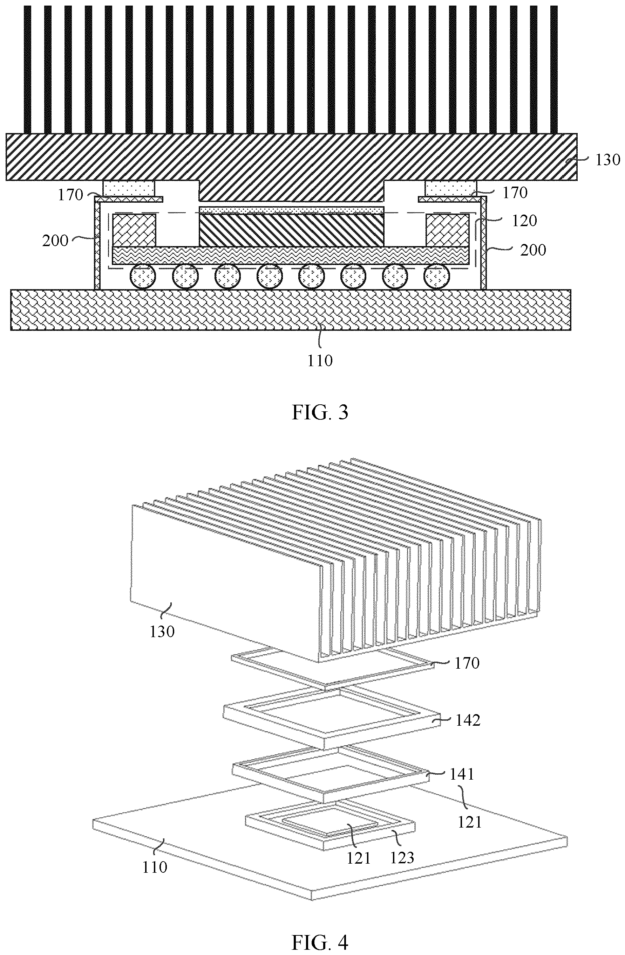

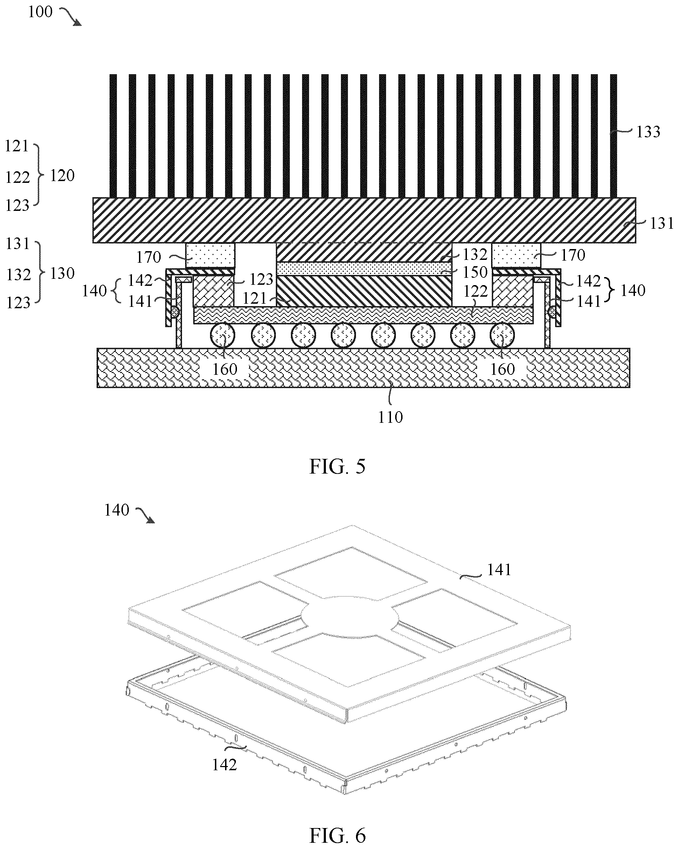

The following describes in detail a specific structure of the circuit board assembly and a manufacturing method of the circuit board assembly with reference to the accompanying drawings. As shown in FIG. 4 and FIG. 5, an embodiment of this application provides a circuit board assembly 100. The circuit board assembly 100 may include a first circuit board 110, a chip component 120, and at least one heat sink 130. One side of the chip component 120 is electrically connected to the first circuit board 110, and the other side of the chip component 120 is in contact with the heat sink 130.

The circuit board assembly 100 may further include at least one first shielding component 140. Specifically, the first shielding component 140 may be located on a periphery of the chip component 120. A material of the first shielding component 140 may be a metal material like a stainless nickel silver base material. This is not limited in this embodiment of this application. As shown in FIG. 6, each first shielding component 140 may include a shielding frame 141 and a shielding cover 142. An end that is of the shielding frame 141 and that is away from the shielding cover 142 is fastened to the first circuit board 110, and at least a part of the shielding cover 142 is located between the chip component 120 and the heat sink 130. In addition, the shielding cover 142 may be a rigid member, and the shielding cover 142 is movably connected to the shielding frame 141, so that the shielding cover 142 can move in a vertical direction relative to the shielding frame 141. It may be understood that the vertical direction herein is a height direction of the chip component 120.

The shielding cover 142 and the shielding frame 141 form a floating detachable contact structure. For example, a floating structure design with a slip fit may be used between the shielding frame 141 and the shielding cover 142 in the vertical direction. In this way, when the shielding cover 142 is in contact with an assembly gap between the chip component 120 and the heat sink 130, the shielding cover 142 can adapt to chips of different heights and move in the vertical direction relative to the shielding frame 141, or the shielding cover 142 can adapt to different assembly gaps between the chip component 120 and the heat sink 130 and move in the vertical direction relative to the shielding frame 141. This resolves a gap tolerance problem of fitting between a shielding can, the chip component 120, and the heat sink 130 in an actual mounting scenario.

It may be understood that the shielding cover 142 may make a movement of a specific preset distance (which may be calculated based on a specific scenario) in the vertical direction relative to the shielding frame 141, so that a space gap of the specific preset distance can effectively be reduced in a case in which the first shielding component 140 does not interfere with the chip component 120 and the heat sink 130, to adapt to chips of different heights, reduce a size deviation of assembly, improve reliability of contact between the shielding cover 142 and the chip component 120 and lower requirements for a height and space. For example, the shielding cover 142 may make a movement of 0.5 mm in the vertical direction relative to the shielding frame 141, so that a space gap of 0.5 mm can be effectively reduced.

In addition, in the conventional technology, when the foregoing structure is subject to drop, vibration or impact, because an acceleration of the heat sink 130 is inconsistent with an acceleration of the chip component 120, the heat sink 130 is easily separated from the chip component 120. Under effect of gravity of the heat sink 130, the heat sink 130 is parallel to or not parallel to a surface of the shielding structure 200, that is, the heat sink 130 is parallel to or not parallel to a ground 300 (as shown in FIG. 2). As a result, the shielding structure 200 is partially under excessive pressure. This causes deformation of the shielding structure 200. In addition, a connection between the shielding structure 200 and a printed circuit board (namely, the first circuit board 110) also has a failure risk, which affects connection reliability.

However, in this embodiment of this application, the shielding cover 142 is in contact with the assembly gap between the chip component 120 and the heat sink 130. This changes a form of force exerted on the first shielding component 140, especially for an application scenario of vibration impact. When the heat sink 130 applies pressure to a heat sink cover, a movable connection between the shielding cover 142 and the shielding frame 141 can provide buffer space for the shielding frame 141, to eliminate or reduce a risk of pressure deformation of the first shielding component 140, and prevent a collision damage to the first circuit board 110 caused by the shielding frame 141, which cause a risk of soldering crack between the shielding frame 141 and the first circuit board 110, and damage connection reliability between the shielding frame 141 and the first circuit board 110.

It may be understood that the shielding cover 142 may make a movement of 0.5 mm in the vertical direction relative to the shielding frame 141, so that deformation of 0.25 mm of the first shielding component 140 can be reduced.

The circuit board assembly 100 provided in this embodiment of this application is coupled to both the first shielding component 140 and the heat sink 130, so that both a heat dissipation function and an electromagnetic shielding function can be implemented. Suppression and shielding effect of the first shielding component 140 may be greater than or equal to 5 dB@20 GHz to 30 GHz. In addition, the first shielding component 140 may adapt to the chip component 120 of a large size (for example, 55 mm to 120 mm), so that a risk of strength deformation or failure of the first shielding component 140 of a large size can be reduced or avoided.

As shown in FIG. 5, the chip component 120 may include a chip body 121 and a second circuit board 122. The chip body 121 is connected to the second circuit board 122, a surface that is of the second circuit board 122 and that is away from the chip body 121 is electrically connected to the first circuit board 110, and a surface that is of the chip body 121 and that is away from the second circuit board 122 is in contact with the heat sink 130. The surface that is of the second circuit board 122 and that is away from the chip body 121 is electrically connected to the first circuit board 110, so that an electrical connection between the chip component 120 and the second circuit board 122 can be implemented. The surface that is of the chip body 121 and that is away from the second circuit board 122 is in contact with the heat sink 130, so that the heat sink 130 can dissipate heat for the chip component 120.

In this embodiment of this application, the circuit board assembly 100 may further include a heat conducting member 150. The heat conducting member 150 is located between the chip body 121 and the heat sink 130. The heat conducting member 150 is disposed between the chip body 121 and the heat sink 130, so that heat conduction performance between the chip body 121 and the heat sink 130 can be improved, and the heat sink 130 better dissipates heat for the chip component 120.

It may be understood that the heat conducting member 150 may be made of any material having a heat conducting function, provided that auxiliary heat transfer or heat dissipation effect can be achieved. This is not limited in this embodiment of this application.

In this embodiment of this application, the chip component 120 may further include a mechanical part 123. The mechanical part 123 and the chip body 121 are located on a same surface of the second circuit board 122, the mechanical part 123 is located on a periphery of the chip body 121, and at least a part of the shielding cover 142 is located between the mechanical part 123 and the heat sink 130.

The mechanical part 123 located on the periphery of the chip body 121 can protect the chip body 121 to some extent, and avoid adverse impact on the chip body 121 caused by large-scale exposure of the chip body 121. In addition, the at least a part of the shielding cover 142 is located between the mechanical part 123 and the heat sink 130, which can also prevent the shielding cover 142 from directly contacting the chip body 121 and causing a collision damage or scratch to the chip body 121.

It should be noted that, as shown in FIG. 4, the mechanical part 123 is generally disposed around an outer circle of the chip body 121, to protect the chip body 121 in an inner circle of the mechanical part 123.

In this embodiment of this application, the second circuit board 122 may be electrically connected to the first circuit board 110 through at least one electrical connector 160, and a projection region of the at least one electrical connector 160 on the first circuit board 110 may be located in a projection region of the first shielding component 140 on the first circuit board 110.

The projection region of the electrical connector 160 on the first circuit board 110 is located in the projection region of the first shielding component 140 on the first circuit board 110. This can ensure that the first shielding component 140 covers the electrical connector 160 and gaps between a plurality of electrical connectors 160, and ensure that the first shielding component 140 suppresses electromagnetic interference to the electrical connector 160, to avoid interference caused by the electromagnetic interference to electrical connection performance between the second circuit board 122 and the first circuit board 110.

In a possible implementation, the electrical connector 160 may be a solder ball, solder paste, or the like. For example, the second circuit board 122 and the first circuit board 110 may be electrically connected by using at least one solder ball or solder paste in a solder ball grid array (Ball Grid Array, BGA) packaging manner.

In this embodiment of this application, the circuit board assembly 100 may further include a second shielding component 170. The second shielding component 170 may be located between the shielding cover 142 and the heat sink 130. Specifically, the second shielding component 170 may be in contact with the shielding cover 142 and the heat sink 130. The second shielding component 170 is disposed between the shielding cover 142 and the heat sink 130, so that effect of shielding interference signals around the chip component 120 can be further enhanced on the basis of electromagnetic interference suppression performed by the first shielding component 140 on the chip component 120.

In some embodiments, the second shielding component 170 may be of an elastic shielding material, namely, a soft compressible shielding material. The second shielding component 170 is set as the elastic shielding material, the second shielding component 170 can provide specific buffering effect for contact between the shielding cover 142 and the heat sink 130 when enhancing the effect of shielding interference signals around the chip component 120. When the heat sink 130 applies pressure to a heat sink cover, the second shielding component 170 can be subject to specific pressure, to reduce a pressure degree of the heat sink cover.

For example, the second shielding component 170 may be a conductive fabric, a conductive adhesive, a spring plate structure, or another conductive material. This is not limited in this embodiment of this application.

It may be understood that the second shielding component 170 may be disposed on the shielding cover 142, or may be disposed on the heat sink 130. For example, the second shielding component 170 may have adhesion performance, and can be attached to the shielding cover 142 or the heat sink 130. In this way, through assembly of the heat sink 130, the second shielding component 170 is located in a sandwich layer between the shielding cover 142 and the heat sink 130, to suppress electromagnetic interference to the chip component 120 and the electrical connector 160.

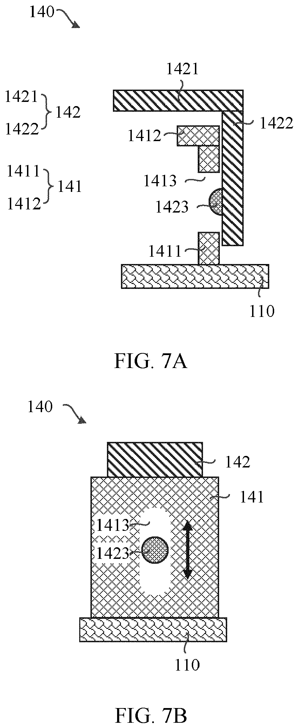

In this embodiment of this application, as shown in FIG. 7A and FIG. 7B, the shielding cover 142 may include a first portion 1421 and a second portion 1422. The first portion 1421 is connected to the second portion 1422, at least a part of the first portion 1421 is located between the chip component 120 and the heat sink 130, and the second portion 1422 is movably connected to the shielding frame 141, so that the shielding cover 142 can move in a vertical direction relative to the shielding frame 141. In this way, the first portion 1421 may make, based on an actual height of the chip component 120 or an assembly gap between the chip component 120 and the heat sink 130, the shielding cover 142 move in the vertical direction relative to the shielding frame 141.

Still refer to FIG. 7A and FIG. 7B. The shielding frame 141 may include a third portion 1411 and a fourth portion 1412. The third portion 1411 is connected to the fourth portion 1412, an end that is of the third portion 1411 and that is away from the fourth portion 1412 is fastened to the first circuit board 110, and the fourth portion 1412 is parallel to the first portion 1421. The fourth portion 1412 is disposed to be parallel to the first portion 1421 of the shielding cover 142, a contact area between the shielding cover 142 and the shielding frame 141 can be increased, to increase a force area when the shielding cover 142 and the shielding frame 141 are in contact with each other, and avoid that when an end that is of the third portion 1411 of the shielding frame 141 and that is away from the first circuit board 110 is in contact with the first portion 1421 of the shielding cover 142, the first portion 1421 of the shielding cover 142 is collided or broken off because an end area of the third portion 1411 of the shielding frame 141 is small.

In a possible implementation, the second portion 1422 may be movably connected to the third portion 1411, so that the shielding cover 142 can move in the vertical direction relative to the shielding frame 141. The second portion 1422 of the shielding cover 142 is movably connected to the third portion 1411 of the shielding frame 141, to ensure that the shielding cover 142 may move relative to the shielding frame 141.

In addition, in this embodiment of this application, the second portion 1422 may be parallel to the third portion 1411. The second portion 1422 of the shielding cover 142 is parallel to the third portion 1411 of the shielding frame 141. When the shielding cover 142 moves relative to the shielding frame 141, it can be ensured that relative position movement directions of the second portion 1422 of the shielding cover 142 and the third portion 1411 of the shielding frame 141 are consistent, to avoid interference or a collision damage caused by a movement of one of the second portion 1422 and the third portion 1411.

It should be noted that, in this embodiment of this application, a movable connection manner between the shielding cover 142 and the shielding frame 141 includes the following three possible implementations.

In a first possible implementation, a protruding portion 1423 is disposed on one of the second portion 1422 and the third portion 1411, an opening 1413 is disposed on one of the second portion 1422 and the third portion 1411, and the protruding portion 1423 may move back and forth in the opening 1413 in a vertical direction. The protruding portion 1423 moves back and forth in the opening 1413 in the vertical direction, so that the shielding cover 142 and the shielding frame 141 can move relative to each other in the vertical direction.

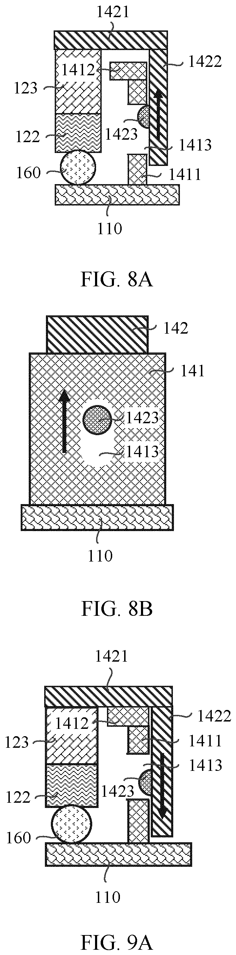

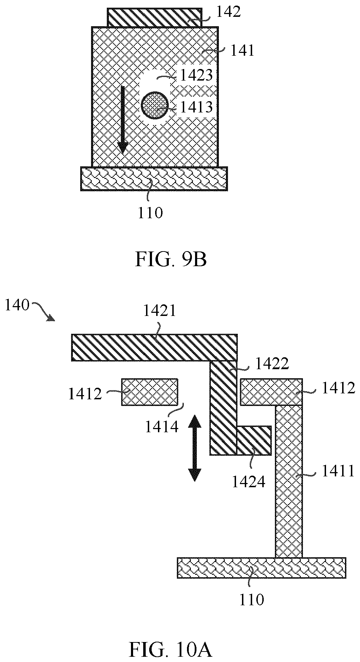

For example, in FIG. 7A and FIG. 7B, the protruding portion 1423 is disposed on the second portion 1422, the opening 1413 is disposed on the third portion 1411, and the protruding portion 1423 may move back and forth in the opening 1413 of the third portion 1411 in the vertical direction. When the protruding portion 1423 moves in the vertical direction to a top wall of the opening 1413 of the third portion 1411, structures shown in FIG. 8A and FIG. 8B are formed. When the protruding portion 1423 moves in the vertical direction to a bottom wall of the opening 1413 of the third portion 1411, structures shown in FIG. 9A and FIG. 9B are formed.

It may be understood that a size of the opening 1413 in the vertical direction may be greater than a size of the protruding portion 1423 in the vertical direction. In this way, it can be ensured that the protruding portion 1423 has specific back-and-forth movement space in the opening 1413 in the vertical direction, so that the shielding cover 142 and the shielding frame 141 can move relative to each other in the vertical direction.

For example, a shape of the opening 1413 on the third portion 1411 may be designed as a shape of a slotted hole shown in FIG. 7B. A length direction of the slotted hole is in the vertical direction, and the protruding portion 1423 moves back and forth in the slotted hole in the length direction of the slotted hole, to form a sliding design in which the protruding portion 1423 matches the slotted hole. This can achieve effect of simple assembly and disassembly.

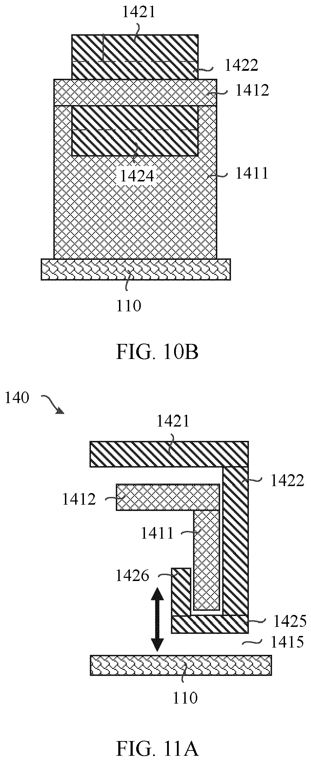

A second possible implementation is as follows. As shown in FIG. 10A and FIG. 10B, a first avoidance opening 1414 is disposed on the fourth portion 1412, the second portion 1422 passes through the first avoidance opening 1414, and the second portion 1422 moves back and forth in an extension direction of the first avoidance opening 1414. The second portion 1422 of the shielding cover 142 passes through the first avoidance opening 1414 on the fourth portion 1412 of the shielding frame 141, and the second portion 1422 of the shielding cover 142 moves back and forth in the extension direction of the first avoidance opening 1414, so that the shielding cover 142 and the shielding frame 141 can move relative to each other in the vertical direction.

In some embodiments, a size of the second portion 1422 in the vertical direction may be greater than a size of the fourth portion 1412 in the vertical direction. In this way, it can be ensured that the second portion 1422 of the shielding cover 142 in the vertical direction has specific back-and-forth movement space in the extension direction of the first avoidance opening 1414, so that the shielding cover 142 and the shielding frame 141 can move relative to each other in the vertical direction.

In addition, it may be understood that, as shown in FIG. 10A and FIG. 10B, the shielding cover 142 may further include a fifth portion 1424. The fifth portion 1424 is connected to an end that is of the second portion 1422 and that is away from the first portion 1421, the fifth portion 1424 is parallel to the fourth portion 1412, and the fifth portion 1424 is configured to limit a movement range of the second portion 1422 when the second portion 1422 moves back and forth in the extension direction of the first avoidance opening 1414.

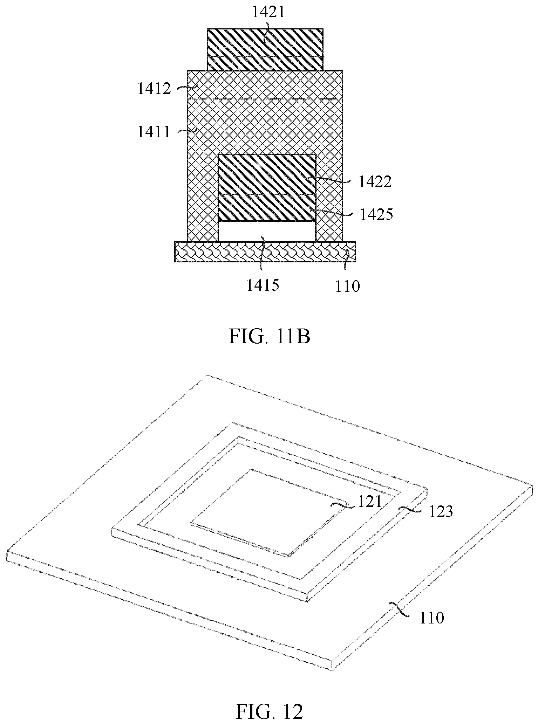

A third possible implementation is as follows. As shown in FIG. 11A and FIG. 11B, a second avoidance opening 1415 is disposed on an end that is of the third portion 1411 and that is close to the first circuit board 110. The shielding cover 142 may further include: a sixth portion 1425. The sixth portion 1425 is connected to an end that is of the second portion 1422 and that is away from the first portion 1421, the sixth portion 1425 extends into the second avoidance opening 1415, and the sixth portion 1425 moves back and forth in the second avoidance opening 1415 in the vertical direction. The sixth portion 1425 of the shielding cover 142 moves back and forth in the second avoidance opening 1415 of the third portion 1411 of the shielding frame 141 in the vertical direction, so that the shielding cover 142 and the shielding frame 141 can move relative to each other in the vertical direction.

In a possible implementation, the shielding cover 142 may further include a seventh portion 1426. The seventh portion 1426 is connected to an end that is of the sixth portion 1425 and that is away from the second portion 1422, and an extension direction of the first portion 1421 is consistent with an extension direction of the second portion 1422.

The seventh portion 1426 is added to the shielding cover 142, the seventh portion 1426 is connected to the end that is of the sixth portion 1425 and that is away from the second portion 1422, and an extension direction of the seventh portion 1426 is consistent with the extension direction of the second portion 1422, so that the seventh portion 1426, the sixth portion 1425, and the second portion 1422 can form an inner bend hook structure. In this way, the shielding cover 142 may closely fit with the shielding frame 141 by using a folded-edge structure (namely, the seventh portion 1426) around the shielding cover 142. Fixed limiting is implemented in front-to-back and left-to-right directions, which helps ensure structural stability when the sixth portion 1425 of the shielding cover 142 moves back and forth in the second avoidance opening 1415 of the third portion 1411 of the shielding frame 141 in the vertical direction. In addition, a sliding design of the inner bend hook structure can also achieve effect of simple assembly and disassembly. The foregoing three floating structures formed between the shielding can and the shielding frame 141 can implement a requirement for floating in a height direction of the chip component 120, so that the shielding cover 142 can be adjusted based on an actual height of the chip component 120. This can effectively meet an electromagnetic shielding requirement, and improve structural strength. In addition, the shielding cover is easy to mount and maintain.

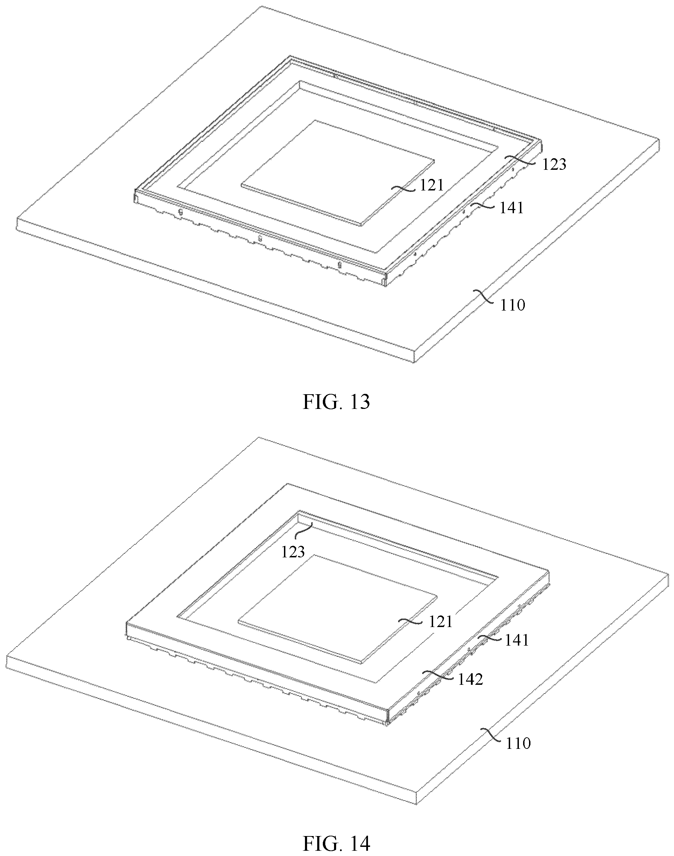

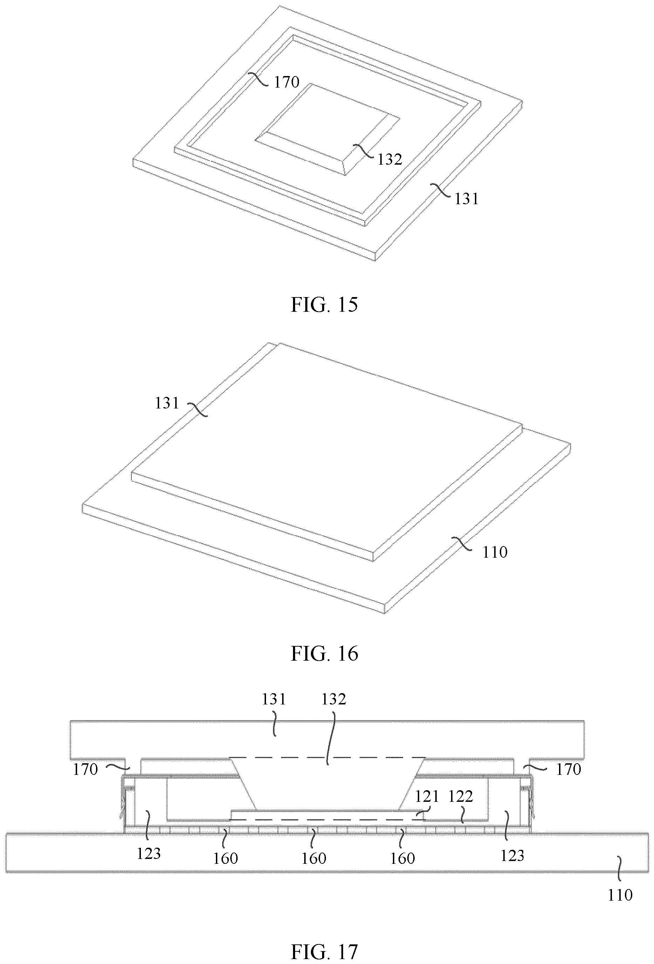

In an actual assembly process, the chip component 120 may be first placed at a specified position (as shown in FIG. 12) on the first circuit board 110, and then the shielding frame 141 is soldered and fastened to the first circuit board 110. Specifically, the shielding frame 141 is disposed on the mechanical part 123 of the chip component 120, to ensure that the shielding frame 141 is disposed around a periphery of the chip body 121 of the chip component 120 (as shown in FIG. 13). Then, the shielding cover 142 is mounted on the shielding frame 141 (as shown in FIG. 14). In this case, the shielding cover 142 and the shielding frame 141 may float up and down, and a height of the shielding cover 142 may be specifically determined based on an actual edge height of the chip component 120. Then, as shown in FIG. 15, the second shielding component 170 is pasted on a bottom surface of the heat sink 130 (namely, a surface of the heat sink 130 facing the first circuit board 110), and the heat sink 130 pasted with the second shielding component 170 is mounted on the chip component 120, so that the heat sink 130 is attached to a heat source surface of the chip body 121 in the chip component 120, and the second shielding component 170 may be in contact with the shielding cover 142, to make the second shielding component 170 press the shielding cover 142 tightly onto the mechanical part 123 of the chip component 120. In this way, the first shielding component 140 and the second shielding component 170 form electrically enclosed space around the chip component 120, to be specific, form the circuit board assembly 100 shown in FIG. 16 and FIG. 17. This effectively implements overall heat dissipation and electromagnetic interference suppression effect.

In a possible implementation, the shielding frame 141 may be soldered and fastened to the first circuit board 110 through a surface mount technology (Surface Mount Technology, SMT), or the shielding frame 141 may be fastened by using a screw fastening manner in which a screw is inserted above or below the first circuit board 110. The heat sink 130 may also be mounted above the chip component 120 in a screw fastening manner.

It should be noted that, the surface mount technology is also referred to as a surface mounted technology, which is a circuit mounting technology in which a leadless or short-lead surface-mount component (chip component) is mounted on a surface of a printed circuit board (Printed Circuit Board, PCB) or a surface of another substrate, and is soldered and assembled through reflow soldering or dip soldering.

In addition, as shown in FIG. 5 or FIG. 17, in this embodiment of this application, the heat sink 130 may include a heat sink body 131 and a boss 132. The boss 132 is connected to the heat sink body 131, and a surface that is of the boss 132 and that is away from the heat sink body 131 is in contact with the chip component 120.

In a possible implementation, the heat sink 130 may further include heat dissipation fins 133, and the heat dissipation fins are fastened on a surface that is of the heat sink body 131 and that is away from the boss 132. The heat dissipation fins 133 can improve heat dissipation effect of the heat sink 130.

An embodiment of this application further provides an electronic device. The electronic device may include any one of the foregoing circuit board assemblies 100.

The foregoing circuit board assembly 100 is disposed in the electronic device. Because the circuit board assembly 100 can adapt to chip components 120 of different heights and different assembly gaps, adaptability of the chip components 120 of different heights and different assembly gaps to the electronic device can be increased. Because reliability of the circuit board assembly 100 is high, the circuit board assembly 100 with high reliability may be disposed in the electronic device, to optimize experience effect of the electronic device. In addition, stability of signal transmission in the electronic device is ensured, and normal operation of the electronic device is ensured.

It should be noted that the electronic device provided in this embodiment of this application may include but is not limited to a mobile phone, a tablet computer, a notebook computer, an ultra-mobile personal computer (ultra-mobile personal computer, UMPC for short), a handheld computer, a walkie-talkie, a netbook, a POS machine, a mobile or fixed terminal having the circuit board assembly 100, like a personal digital assistant (personal digital assistant, PDA for short), a wearable device, or a virtual reality device.

In descriptions of embodiments of this application, it should be noted that, unless otherwise clearly specified and limited, terms "installation", "connection", and "connected" should be understood in a broad sense. For example, the connection may be a fixed connection, may be an indirect connection through an intermediate medium, or may be an internal connection between two elements or an interaction relationship between two elements. Persons of ordinary skill in the art may understand specific meanings of the terms in embodiments of this application based on specific cases.

In embodiments of this application, it is implied that an apparatus or element in question needs to have a particular orientation, or needs to be constructed and operated in a particular orientation, and therefore cannot be construed as a limitation on embodiments of this application. In the description of embodiments of this application, unless otherwise exactly and specifically ruled, "a plurality of" means two or more than two.

In the specification, claims, and accompanying drawings of embodiments of this application, terms "first", "second", "third", "fourth", and the like (if exist) are intended to distinguish between similar objects but do not necessarily indicate a specific order or sequence. It may be understood that the data used in such a way is interchangeable in proper circumstances, so that embodiments of this application described herein can be implemented in other sequences than the sequence illustrated or described herein. Moreover, terms "may include" and "have" and any other variants are intended to cover non-exclusive inclusion. For example, a process, method, system, product, or device that includes a list of steps or units is not necessarily limited to those expressly listed steps or units, but may include other steps or units not expressly listed or inherent to such a process, method, product, or device.

Finally, it should be noted that the foregoing embodiments are merely used to describe the technical solutions in embodiments of this application, but are not intended to limit the technical solutions. Although embodiments of this application are described in detail with reference to the foregoing embodiments, persons of ordinary skill in the art should understand that the technical solutions described in the foregoing embodiments may still be modified, or some or all technical features thereof may be equivalently replaced. However, these modifications or replacements do not depart from the scope of the technical solutions of embodiments of this application.

## Claims

1. A circuit board assembly, at least comprising:
a first circuit board, a chip component, and at least one heat sink, wherein
one side of the chip component is electrically connected to the first circuit board, and the other side of the chip component is in contact with the heat sink; and
further comprising: at least one first shielding component located on a periphery of the chip component, wherein each first shielding component comprises a shielding frame and a shielding cover;
an end that is of the shielding frame and that is away from the shielding cover is fastened to the first circuit board, and at least a part of the shielding cover is located between the chip component and the heat sink; and
the shielding cover is movably connected to the shielding frame, so that the shielding cover is capable of moving in a vertical direction relative to the shielding frame.

2. The circuit board assembly according to claim 1, wherein the chip component comprises a chip body and a second circuit board connected to the chip body; and
a surface that is of the second circuit board and that is away from the chip body is electrically connected to the first circuit board, and a surface that is of the chip body and that is away from the second circuit board is in contact with the heat sink.

3. The circuit board assembly according to claim 2, further comprising a heat conducting member, wherein the heat conducting member is located between the chip body and the heat sink.

4. The circuit board assembly according to claim 2, wherein the chip component further comprises a mechanical part, the mechanical part and the chip body are located on a same surface of the second circuit board, and the mechanical part is located on a periphery of the chip body; and
the at least a part of the shielding cover is located between the mechanical part and the heat sink.

5. The circuit board assembly according to claim 2, wherein the second circuit board is electrically connected to the first circuit board through at least one electrical connector; and
a projection region of the at least one electrical connector on the first circuit board is located in a projection region of the first shielding component on the first circuit board.

6. The circuit board assembly according to claim 1, further comprising at least one second shielding component, wherein the second shielding component is located between the shielding cover and the heat sink.

7. The circuit board assembly according to claim 6, wherein the second shielding component is of an elastic shielding material.

8. The circuit board assembly according to any one of claims 1 to 7, wherein the shielding cover comprises a first portion and a second portion connected to the first portion; and
at least a part of the first portion is located between the chip component and the heat sink, and the second portion is movably connected to the shielding frame, so that the shielding cover is capable of moving in the vertical direction relative to the shielding frame.

9. The circuit board assembly according to claim 8, wherein the shielding frame comprises a third portion and a fourth portion connected to the third portion; and
an end that is of the third portion and that is away from the fourth portion is fastened to the first circuit board, and the fourth portion is parallel to the first portion.

10. The circuit board assembly according to claim 9, wherein the second portion is movably connected to the third portion, so that the shielding cover is capable of moving in the vertical direction relative to the shielding frame.

11. The circuit board assembly according to claim 10, wherein the second portion is parallel to the third portion.

12. The circuit board assembly according to claim 10 or 11, wherein a protruding portion is disposed on one of the second portion and the third portion, and an opening is disposed on one of the second portion and the third portion; and
the protruding portion moves back and forth in the opening in the vertical direction.

13. The circuit board assembly according to claim 12, wherein a size of the opening in the vertical direction is greater than a size of the protruding portion in the vertical direction.

14. The circuit board assembly according to claim 10 or 11, wherein a first avoidance opening is disposed on the fourth portion; and
the second portion passes through the first avoidance opening, and the second portion moves back and forth in an extension direction of the first avoidance opening.

15. The circuit board assembly according to claim 14, wherein a size of the second portion in the vertical direction is greater than a size of the fourth portion in the vertical direction.

16. The circuit board assembly according to claim 14, wherein the shielding cover further comprises: a fifth portion;
the fifth portion is connected to an end that is of the second portion and that is away from the first portion; and
the fifth portion is parallel to the fourth portion, and the fifth portion is configured to limit a movement range of the second portion when the second portion moves back and forth in the extension direction of the first avoidance opening.

17. The circuit board assembly according to claim 10 or 11, wherein a second avoidance opening is disposed on an end that is of the third portion and that is close to the first circuit board;
the shielding cover further comprises a sixth portion, wherein the sixth portion is connected to an end that is of the second portion and that is away from the first portion; and
the sixth portion extends into the second avoidance opening, and the sixth portion moves back and forth in the second avoidance opening in the vertical direction.

18. The circuit board assembly according to claim 17, wherein the shielding cover further comprises a seventh portion, and the seventh portion is connected to an end that is of the sixth portion and that is away from the second portion; and
an extension direction of the seventh portion is consistent with an extension direction of the second portion.

19. The circuit board assembly according to claim 1, wherein the heat sink comprises a heat sink body and a boss connected to the heat sink body; and
a surface that is of the boss and that is away from the heat sink body is in contact with the chip component.

20. An electronic device, comprising the circuit board assembly according to any one of claims 1 to 19.
